# EUROPEAN PATENT APPLICATION

(11) **EP 4 459 468 A1**
(43) Date of publication of application: **06.11.2024**
(21) Application number: 23216033.3
(22) Date of filing: 12.12.2023
(51) Int. Cl.: G06F 11/10, G06F 12/02, G11C 5/04, G11C 29/52, G11C 11/401, G11C 29/42, G06F 12/0888

(54) **STORAGE AND ACCESS OF METADATA WITHIN SELECTIVE DYNAMIC RANDOM ACCESS MEMORY (DRAM) DEVICES**

(30) Priority: 04.05.2023 US 202363464163 P; 20.06.2023 US 202318212057
(71) Applicant: INTEL Corporation, Santa Clara, CA 95054 (US)
(72) Inventor: HINCK, Todd, Santa Clara, 95054 (US); BAINS, Kuljit S., Santa Clara, 95054 (US)
(74) Representative: Rummler, Felix

(57) **Abstract**

Techniques for storing and accessing metadata within selective dynamic random access memory (DRAM) devices are described. In one example, a dual in-line memory module (DIMM) includes a plurality of dynamic random access memory (DRAM) devices, wherein each of plurality of DRAM devices includes on-die ECC bits. At least one of the plurality of DRAM devices includes circuitry to provide access to read from and write to the on-die ECC bits of the DRAM device. The DIMM includes one or more pins to transmit metadata to and from the on-die ECC bits of the DRAM device.

## Description

### RELATED APPLICATION

The present application claims the benefit of priority of U.S. Provisional Patent Application No. 63/464,163, filed May 4, 2023, entitled "STORAGE AND ACCESS OF METADATA WITHIN SELECTIVE DYNAMIC RANDOM ACCESS MEMORY (DRAM) DEVICES," the entire contents of which is incorporated herein by reference in its entirety.

### FIELD

Descriptions are generally related to computer memory, and more particular descriptions are related to storage and access of metadata in dynamic random access memory (DRAM) devices.

### BACKGROUND

The performance of computing systems is highly dependent on the performance of their system memory. Memory systems use metadata for various purposes. For example, metadata can have any of multiple uses such as storing any or all of the following kinds of meta data: security, directory, poison, cache tags, integrity, encryption, decryption, compression, memory hierarchy bits, and/or other metadata.

### BRIEF DESCRIPTION OF THE DRAWINGS

The following description includes discussion of figures having illustrations given by way of example of implementations of embodiments of the invention. The drawings should be understood by way of example, and not by way of limitation. As used herein, references to one or more "embodiments" or examples are to be understood as describing a particular feature, structure, and/or characteristic included in at least one implementation of the invention. Thus, phrases such as "in one embodiment" or "in an alternate embodiment" appearing herein describe various embodiments and implementations of the invention, and do not necessarily all refer to the same embodiment. However, they are also not necessarily mutually exclusive.
**Figure 1A** illustrates an example of a DIMM in which techniques for storing and accessing metadata within selective DRAM devices can be implemented.
**Figure 1B** illustrates an example of a DIMM in a DIMM connector.
**Figure 2** illustrates an example of a DIMM with a data buffer in which techniques for storing and accessing metadata within selective DRAM devices can be implemented.
**Figure 3** illustrates an example of DDR5 x4 devices with an on-die ECC metadata storage and access scheme.
**Figure 4** illustrates an example of DDR6 x4 devices with an on-die ECC metadata storage and access scheme.
**Figure 5** illustrates an example of DDR6 x8 devices with an on-die ECC metadata storage and access scheme.
**Figure 6** is an example of a state machine diagram for a DRAM device in which an on-die ECC metadata storage and access scheme is implemented.
**Figure 7** illustrates two examples of timing diagrams for DRAM devices with an on-die ECC metadata storage and access scheme.
**Figure 8** is a block diagram of an embodiment of a memory subsystem in which techniques for storing and accessing metadata within selective DRAM devices can be implemented.
**Figure 9** is a block diagram of an embodiment of a computing system in which techniques for storing and accessing metadata within selective DRAM devices can be implemented.

Descriptions of certain details and implementations follow, including a description of the figures, which may depict some or all of the embodiments described below, as well as discussing other potential embodiments or implementations of the inventive concepts presented herein.

### DETAILED DESCRIPTION

Techniques for storing and accessing metadata within selective dynamic random access memory (DRAM) devices are described.

In some conventional solutions, bits from the standard ECC are used to store metadata. For example, a certain number of ECC bits are made available on a DIMM by using one or more DRAM chips as ECC devices. For example, in DDR5, two ECC devices provide 128 ECC bits on a DIMM. Thus, in one such example, the 128 data (DQ) bits of the DRAM devices used for ECC are the ECC bits for the DIMM. In one such example, some of those 128 ECC bits are reappropriated for storing metadata. Using the ECC bits from the ECC devices reduces the RAS coverage on the DIMM and can result in providing less than 100% single-device data correction (SDDC).

In contrast, storing metadata within the on-die ECC bits of one or more devices on a memory channel provides a way to store metadata without losing capacity at the DIMM level, without sacrificing performance by extending the data burst length or requiring longer core timing parameters, and without reducing RAS capabilities. In one example, the on-die ECC bits would be accessed via a single bit in parallel with normal data bits within the device. In one example, the on-die ECC bits from multiple devices can be collated via a buffer device to minimize the number of bit streams back to the host device.

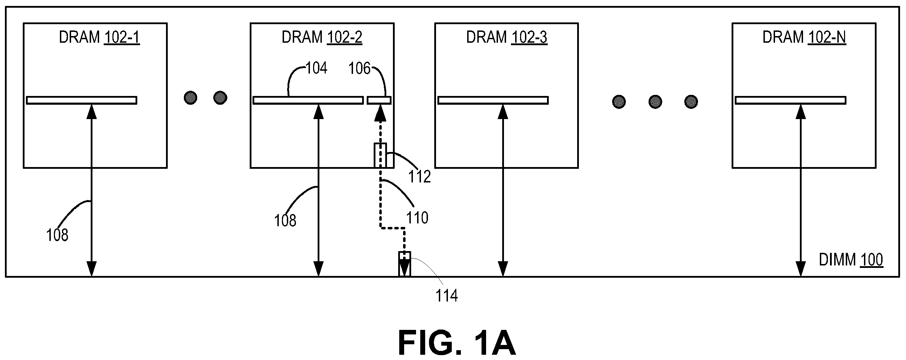

**Figure 1A** illustrates an example of a DIMM 100 in which techniques for storing and accessing metadata within selective DRAM device can be implemented. The DIMM 100 can be any of a variety of types DIMMs, such as an unbuffered or unregistered DIMM (UDIMM), a registered DIMM (RDIMM), a load reduced DIMM (LRDIMM), an enhanced load reduced DIMM (eLRDIMM), a multi-ranked buffered DIMM (MRDIMM), or other type of DIMM.

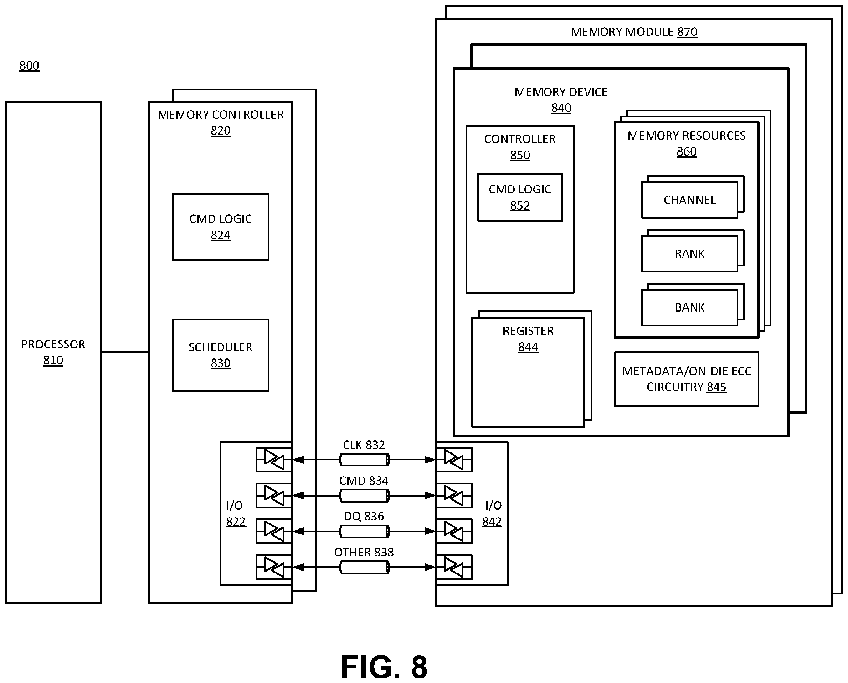

The DIMM 100 includes DRAM devices 102-1-102-N (also referred to as DRAM chips, memory devices, or memory chips). Figure 8, discussed below, includes an example of a memory module 870 including memory devices 840, which may be the same as or similar to the DRAM devices 102-1-102-N. Referring again to Figure 1A, each of the DRAM devices 102-1-102-N includes a data array 104 and an on-die ECC array 106. The ratio of data bits to on-die ECC bits is implementation specific. In one example, each 128 bits of data has 8 bits of on-die ECC. For the most part, this on-die ECC only protects against single bit errors. In addition to the single bit error protection provided by the on-die ECC 106, the DIMM 100 may have ECC devices on the DIMM 100 that provide at least single bit error protection. For example, one or more of the DRAM devices 102-1-102-N are ECC DRAM devices (e.g., DRAM devices used for storing ECC bits), and the remaining are data DRAM devices (e.g., DRAM devices used for storing data). For example, referring to Figure 1A, if the DIMM 100 has 20 DRAM devices (e.g., N=20), four of the DRAM devices can be dedicated to storing ECC bits, and the remaining 16 devices can be dedicated to storing data. Thus, some DIMMs include ECC protection in two forms: the on-die ECC bits of each DRAM device, and one or more dedicated ECC devices on the DIMM.

In conventional DRAMs, the on-die ECC 106 is not accessible off the chip. For example, on-die ECC is handled entirely internally within the DRAM device and cannot be read or otherwise accessed by a host (e.g., memory controller). Thus, in conventional DRAM devices, there is no path connecting the on-die ECC bits to the pins of the DRAM, and thus there is no path connecting the on-die ECC bits to the pins of the DIMM.

In contrast, the DRAM 102 and DIMM 100 includes a path to enable reading from and writing to the on-die ECC bits 106. For example, at least one of the DRAM devices 102-1-102-N includes one or more conductive contacts or pins 112 (e.g., an on-die ECC pin) via which the on-die ECC 106 can be accessed by a host. In the example of Figure 1A, the DRAM device 102-2 is shown as having a pin 112 to route the on-die ECC off the chip. The pin 112 of the DRAM chip 102-2 is coupled with one or more conductive contacts (e.g., pins or gold fingers) of the DIMM 100.

In addition to the conductive interconnects 108 (e.g., wires, traces, buses, and/or other conductive interconnects) that connect the data arrays 104-1-104-N of the DRAM devices 102-1-102-N, one or more conductive interconnects 110 couple the on-die ECC bits 106 with the on-die ECC pin 112 of the DRAM device 102-2 and one or more pins 114 of DIMM 100. Thus, in the illustrated example, the DRAM device 102-2 includes an on-die ECC pin 112 coupled with one or more pins 114 of the DIMM 100 to transmit metadata to and from the on-die ECC bits 106 of the DRAM device 102-2. In one example, in a DDRx memory system, one extra pin of the selected DRAM device(s), and four extra pins per DIMM would go back to the host for accessing the on-die ECC. For example, the on-die ECC pin of one or more DRAM devices is routed to one or more on-die ECC pins of the DIMM 100, which couple with contacts of a DIMM connector to enable host access.

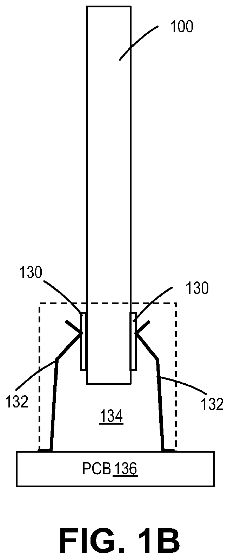

**Figure 1B** illustrates an example of the DIMM 100 in a DIMM connector 134. The DIMM 100 can be inserted or seated into the socket of the DIMM connector 134 on the PCB or motherboard 136. The connector 134 includes pins 132 that make contact with pins 130 of the DIMM 100. The pins 130 couple with the DRAM chips 102-1-102-N on the DIMM 100 via conductive traces on or in the DIMM 100. In this way, signals can be transmitted to and from the DRAM chips 102-1-102-N via the connector 134.

Referring again to Figure 1A, note that in the illustrated example, one DRAM device 102-2 is shown as having its on-die ECC bits routed off the device. In one example, all the DRAM devices 102-1-102-N include an on-die ECC pin; however, only one or a subset of the DRAM devices have their on-die ECC pin coupled with the corresponding pins 114 of the DIMM 100. In one example, devices where the on-die ECC bits are not selectable will not be accessible by not routing their on-die ECC pin to the corresponding pins 114 at the DIMM connector edge. For such devices in which the on-die ECC is not selectable, the on-die ECC pin could be left open or connected to VDD or VSS to ground it. In one such example, the DRAM device can be configured to disable the I/O capability of the on-die ECC pin. For example, the DRAM device can include one or more registers to store a value to enable reading metadata from and writing metadata to the on-die ECC bits.

Thus, in the example in Figure 1A, the DIMM 100 includes a plurality of dynamic random access memory (DRAM) devices, each having on-die ECC bits. At least one of the plurality of DRAM devices includes circuitry to provide access to read from and write to the on-die ECC bits of the DRAM device. The selected DRAM device(s) includes a read/write (R/W) pin to transmit metadata to and from the on-die ECC bits of the DRAM device, and the on-die ECC bits 106 are routed to the on-die ECC pin to enable the host device to store metadata bits in the on-die ECC bits of one or more selected DRAM devices of the DIMM 100.

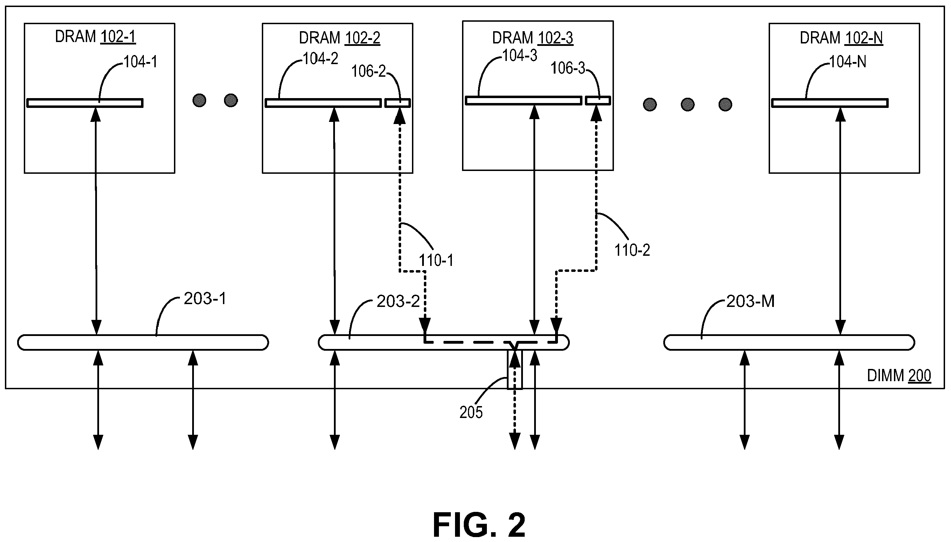

**Figure 2** illustrates an example of a DIMM 200 with data buffers 203-203-M in which techniques for storing and accessing metadata within selective DRAM device can be implemented. In the case where a data buffer DIMM architecture is being used, like an LRDIMM, MRDIMM, or other buffered DIMM architecture, we can collate the metadata lanes to reduce the number of pins going back to the host. In the example in Figure 2, there are two DRAM devices 102-2, 102-3 with on-die ECC bits 106-2, 106-3 that are being used for metadata storage. In this example, the bits are collected or collated in the data buffer 203-2 and the collated metadata is transmitted over one or more pins 205. Thus, in some examples, the DIMM can include a data buffer to collate the metadata to and from the on-die ECC bits of the multiple DRAM devices.

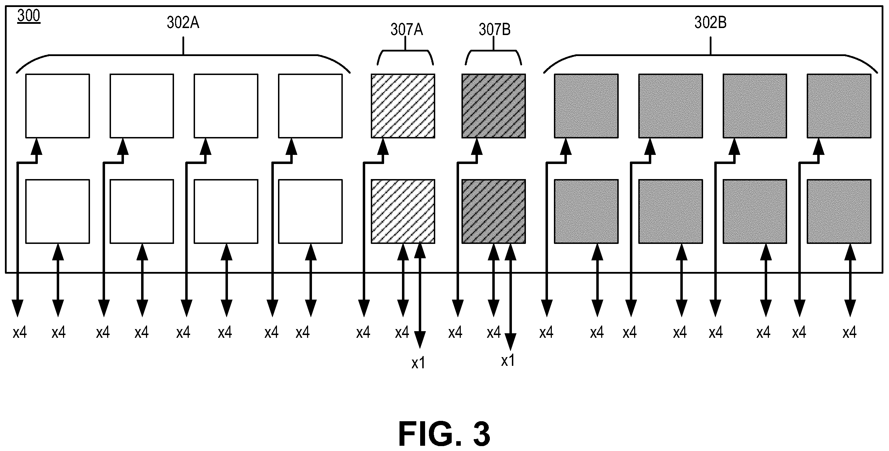

**Figure 3** illustrates an example of a DIMM with DDR5 x4 devices with an on-die ECC metadata storage and access scheme. In the example in Figure 3, there are two channels, each channel having eight data DRAM devices and two ECC DRAM devices for a total of sixteen data DRAM devices 302A, 302B and four ECC DRAM devices 307A, 307B on the DIMM 300. For example, a first channel A includes data DRAM devices 302A and ECC DRAM devices 307A, and a second channel B includes data DRAM devices 302B and ECC DRAM devices 307B. The data DRAM devices 302A, 302B store data and the ECC DRAM devices 307A, 307B store ECC bits to provide error correction capabilities for the DIMM. In the illustrated example, each channel includes 32 data bits and 8 ECC bits.

Unlike conventional DIMMs, in the example of Figure 3, the on-die ECC bits of two of the ECC devices (e.g., one ECC device per channel) are routed off the ECC devices to one or more pins of the DIMM 300. In the example illustrated in Figure 3, one of the ECC DRAM devices per channel is selected for storing metadata in the device's on-die ECC bits. Thus, in this example, there is a path to read and write the on-die ECC bits of two of the ECC devices (e.g., one of the ECC devices 307A and one of the ECC devices 307B). Thus, in addition to the 32 bits of data and 8 bits of ECC per channel, there is one metadata/on-die ECC bit per channel for a total of 82 bits.

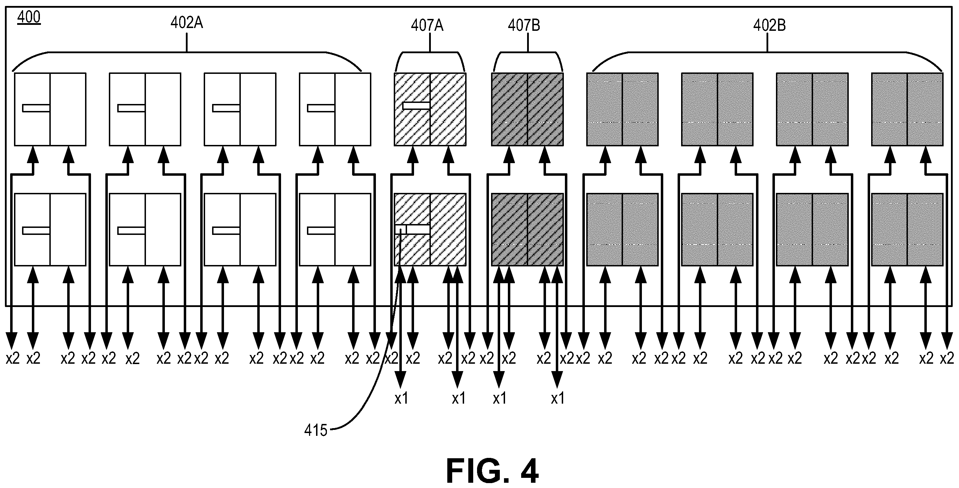

**Figure 4** illustrates an example of DDR6 x4 devices with an on-die ECC metadata storage and access scheme. The example in Figure 4 is based on a pseudo split die with two channels, each channel having eight pseudo split x4 DRAM devices for data and two pseudo split x4 DRAM devices for ECC for a total of sixteen pseudo split data DRAM devices 402A, 402B and four pseudo split ECC DRAM devices 407A, 407B on the DIMM 400. For example, a first channel A includes data DRAM devices 402A and ECC DRAM devices 407A, and a second channel B includes data DRAM devices 402B and ECC DRAM devices 407B. In the illustrated example, each channel includes 32 data bits and 8 ECC bits.

In the example of Figure 4, the on-die ECC bits of four of the ECC device halves (e.g., one ECC device or two ECC device halves per channel) are routed off the ECC devices to one or more pins of the DIMM 400. In the example illustrated in Figure 4, one of the pseudo split ECC DRAM devices per channel is selected for storing metadata in the device's on-die ECC bits. For example, the on-die ECC bits 415 are shown for one half of a pseudo split ECC device. Thus, in this example, there is a path to read and write the on-die ECC bits of four of the half-ECC devices (e.g., two bits from one of the pseudo split ECC devices 407A and two bits from one of the pseudo split ECC devices 407B). Thus, in addition to the 32 bits of data and 8 bits of ECC per channel, there are two metadata/on-die ECC bits per channel for a total of 84 bits.

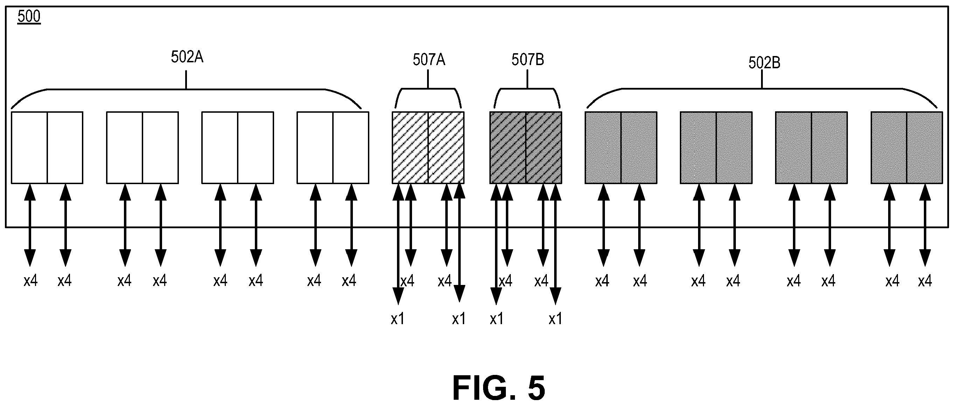

**Figure 5** illustrates an example of DDR6 x8 devices with an on-die ECC metadata storage and access scheme. The example in Figure 5 is based on a pseudo split die with two channels, each channel having four pseudo split x8 DRAM devices for data and two pseudo split x8 DRAM devices for ECC for a total of eight pseudo split data DRAM devices 502A, 502B and four pseudo split ECC DRAM devices 507A, 507B on the DIMM 500. For example, a first channel A includes data DRAM devices 502A and ECC DRAM devices 507A, and a second channel B includes data DRAM devices 502B and ECC DRAM devices 507B. In the illustrated example, each channel includes 32 data bits and 8 ECC bits.

In the example of Figure 5, the on-die ECC bits of each of the four ECC device halves (e.g., one ECC device or two ECC device halves per channel) are routed off the ECC devices to one or more pins of the DIMM 500. Thus, in this example, there is a path to read and write the on-die ECC bits of the four half-ECC devices (e.g., two bits from the pseudo split ECC device 507A and two bits from the pseudo split ECC device 507B). Thus, in addition to the 32 bits of data and 8 bits of ECC per channel, there are two metadata/on-die ECC bits per channel for a total of 84 bits.

Figures 1-5 illustrate some specific examples of DIMMs and DRAM devices in which an on-die ECC metadata storage and access scheme is implemented, however, other examples are possible. For example, different implementations may expose the on-die ECC bits of one of the DRAM devices per channel or per DIMM. In one example, the on-die ECC pin of only one of the plurality of DRAM devices per channel is coupled with the corresponding pins of the DIMM. In another example, the on-die ECC pins of multiple DRAM devices (e.g., a subset or all of the DRAM devices on the DIMM) are coupled with the corresponding pins of the DIMM. Although specific examples discussed above show the ECC DRAM device as selected for storing metadata in the on-die ECC bits, the on-die ECC bits of the data DRAM devices can also, or alternatively, be used to store metadata.

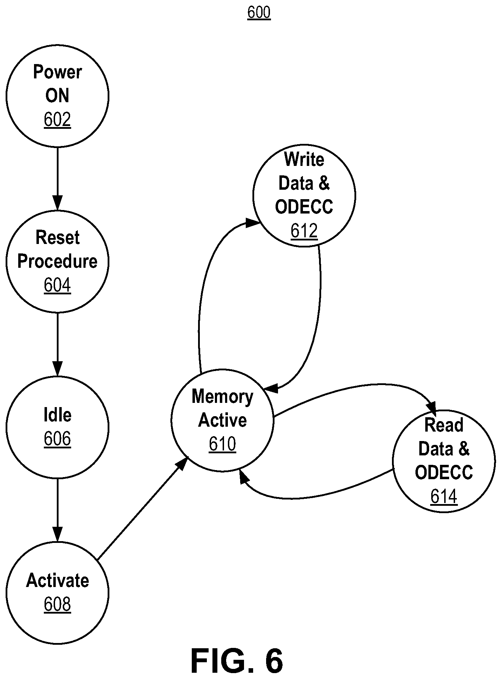

**Figure 6** is an example of a state machine diagram 600 for a DRAM device in which an on-die ECC metadata storage and access scheme is implemented. The state machine diagram 600 starts with power on, at state 602. After power on, the DRAM device performs a reset procedure, at state 604. In one example, after completion of the reset procedure, the DRAM device is idle, at state 606, until receiving an activate command, at state 608. Once the DRAM device is activated, at state 610, a read or write command can be received and handled. For example, the DRAM device performs a write, at state 612, when a write command is received after the activate command. In one example, when performing a write command, the on-die ECC bits (ODECC) are also written. For example, the values received via the on-die ECC pin of the DRAM device (e.g., the pin 112 of Figure 1A) are written to the devices on-die ECC bits. In another example, the DRAM device performs a read, at state 614, when a read command is received after the activate command. In one example, when performing a read command, the on-die ECC bits (ODECC) are also read. For example, the values stored in the on-die ECC bits are read and transmitted via the on-die ECC pin of the DRAM device.

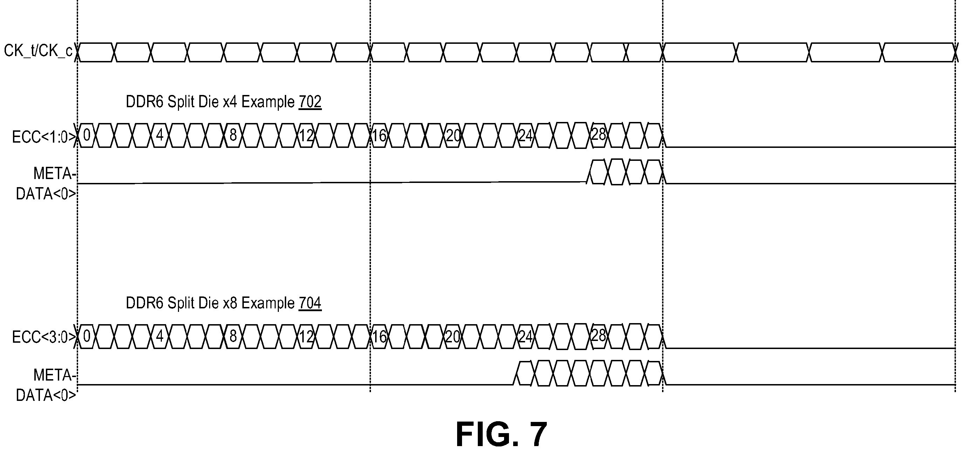

**Figure 7** illustrates two examples of timing diagrams for DRAM devices with an on-die ECC metadata storage and access scheme. The timing diagram example 702 is for a x4 DDR6 split die, such as the example illustrated in Figure 4. The timing diagram example 704 is for a x8 DDR6 split die, such as the example illustrated in Figure 5.

Referring first to the DDR6 split die x4 example 702, an ECC DRAM device (e.g., one half of one of the ECC DRAM devices 407A) transmits 32 bits of ECC data over its data signal lines (ECC<1:0>) in response to a read or write command. Also, in response to the read or write command, four bits of metadata are transmitted over its on-die ECC/metadata signal line (METADATA<0>).

Referring to the DDR6 split die x8 example 704, an ECC DRAM device (e.g., one half of the ECC DRAM device 507A) transmits 32 bits of ECC data over its data signal lines (ECC<3:0>) in response to a read or write command. Also, in response to the read or write command, eight bits of metadata are transmitted over its on-die ECC/metadata signal line (METADATA<0>). Thus, in one example, for a DRAM device configured to route the on-die ECC bits off the device, the on-die ECC bits are accessed for every read and write for all addresses.

Thus, techniques for exposing the on-die ECC bits of one or more selected DRAM devices on a DIMM can enable storing metadata in the on-die ECC bits without compromising the ECC coverage for the DIMM.

**Figure 8** is a block diagram of an embodiment of a memory subsystem in which techniques for storing and accessing metadata within selective DRAM devices can be implemented. System 800 includes a processor and elements of a memory subsystem in a computing device. Processor 810 represents a processing unit of a computing platform that may execute an operating system (OS) and applications, which can collectively be referred to as the host or the user of the memory. The OS and applications execute operations that result in memory accesses. Processor 810 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination. Memory accesses may also be initiated by devices such as a network controller or hard disk controller. Such devices can be integrated with the processor in some systems or attached to the processer via a bus (e.g., PCI express), or a combination. System 800 can be implemented as an SOC (system on a chip) or be implemented with standalone components.

Reference to memory devices can apply to different memory types. "Memory devices" often refers to volatile memory technologies. Volatile memory is memory whose state (and therefore the data stored in it) is indeterminate if power is interrupted to the device. Dynamic volatile memory requires refreshing the data stored in the device to maintain state. One example of dynamic volatile memory incudes DRAM (Dynamic Random Access Memory), or some variant such as Synchronous DRAM (SDRAM). A memory subsystem as described herein may be compatible with a number of memory technologies, such as DDR3 (Double Data Rate version 3, original release by JEDEC (Joint Electronic Device Engineering Council) on June 27, 2007). DDR4 (DDR version 4, originally published in September 2012 by JEDEC), DDR5 (DDR version 5, originally published in July 2020), DDR6, LPDDR3 (Low Power DDR version 3, JESD209-3B, August 2013 by JEDEC), LPDDR4 (LPDDR version 4, JESD209-4, originally published by JEDEC in August 2014), LPDDR5 (LPDDR version 5, JESD209-5A, originally published by JEDEC in January 2020), WIO2 (Wide Input/Output version 2, JESD229-2 originally published by JEDEC in August 2014), HBM (High Bandwidth Memory, JESD235, originally published by JEDEC in October 2013), HBM2 (HBM version 2, JESD235C, originally published by JEDEC in January 2020), or HBM3 (HBM version 3 currently in discussion by JEDEC), or others or combinations of memory technologies, and technologies based on derivatives or extensions of such specifications. The JEDEC standards are available at www.jedec.org.

Descriptions herein referring to a "RAM" or "RAM device" can apply to any memory device that allows random access, whether volatile or nonvolatile. Descriptions referring to a "DRAM" or a "DRAM device" can refer to a volatile random access memory device. The memory device or DRAM can refer to the die itself, to a packaged memory product that includes one or more dies, or both. In one embodiment, a system with volatile memory that needs to be refreshed can also include nonvolatile memory.

Memory controller 820 represents one or more memory controller circuits or devices for system 800. Memory controller 820 represents control logic that generates memory access commands in response to the execution of operations by processor 810. Memory controller 820 accesses one or more memory devices 840. Memory devices 840 can be DRAM devices in accordance with any referred to above. In one embodiment, memory devices 840 are organized and managed as different channels, where each channel couples to buses and signal lines that couple to multiple memory devices in parallel. Each channel is independently operable. Thus, each channel is independently accessed and controlled, and the timing, data transfer, command and address exchanges, and other operations are separate for each channel. Coupling can refer to an electrical coupling, communicative coupling, physical coupling, or a combination of these. Physical coupling can include direct contact. Electrical coupling includes an interface or interconnection that allows electrical flow between components, or allows signaling between components, or both. Communicative coupling includes connections, including wired or wireless, that enable components to exchange data.

In one embodiment, settings for each channel are controlled by separate mode registers or other register settings. In one embodiment, each memory controller 820 manages a separate memory channel, although system 800 can be configured to have multiple channels managed by a single controller, or to have multiple controllers on a single channel. In one embodiment, memory controller 820 is part of host processor 810, such as logic implemented on the same die or implemented in the same package space as the processor.

Memory controller 820 includes I/O interface logic 822 to couple to a memory bus, such as a memory channel as referred to above. I/O interface logic 822 (as well as I/O interface logic 842 of memory device 840) can include pins, pads, connectors, signal lines, traces, or wires, or other hardware to connect the devices, or a combination of these. I/O interface logic 822 can include a hardware interface. As illustrated, I/O interface logic 822 includes at least drivers/transceivers for signal lines. Commonly, wires within an integrated circuit interface couple with a pad, pin, or connector to interface signal lines or traces or other wires between devices. I/O interface logic 822 can include drivers, receivers, transceivers, or termination, or other circuitry or combinations of circuitry to exchange signals on the signal lines between the devices. The exchange of signals includes at least one of transmit or receive. While shown as coupling I/O 822 from memory controller 820 to I/O 842 of memory device 840, it will be understood that in an implementation of system 800 where groups of memory devices 840 are accessed in parallel, multiple memory devices can include I/O interfaces to the same interface of memory controller 820. In an implementation of system 800 including one or more memory modules 870, I/O 842 can include interface hardware of the memory module in addition to interface hardware on the memory device itself. Other memory controllers 820 will include separate interfaces to other memory devices 840.

The bus between memory controller 820 and memory devices 840 can be implemented as multiple signal lines coupling memory controller 820 to memory devices 840. The bus may typically include at least clock (CLK) 832, command/address (CMD) 834, and write data (DQ) and read data (DQ) 836, and zero or more other signal lines 838. In one embodiment, a bus or connection between memory controller 820 and memory can be referred to as a memory bus. The signal lines for CMD can be referred to as a "C/A bus" (or ADD/CMD bus, or some other designation indicating the transfer of commands (C or CMD) and address (A or ADD) information) and the signal lines for write and read DQ can be referred to as a "data bus." In one embodiment, independent channels have different clock signals, C/A buses, data buses, and other signal lines. Thus, system 800 can be considered to have multiple "buses," in the sense that an independent interface path can be considered a separate bus. It will be understood that in addition to the lines explicitly shown, a bus can include at least one of strobe signaling lines, alert lines, auxiliary lines, or other signal lines, or a combination. It will also be understood that serial bus technologies can be used for the connection between memory controller 820 and memory devices 840. An example of a serial bus technology is 8B10B encoding and transmission of high-speed data with embedded clock over a single differential pair of signals in each direction. In one embodiment, CMD 834 represents signal lines shared in parallel with multiple memory devices. In one embodiment, multiple memory devices share encoding command signal lines of CMD 834, and each has a separate chip select (CS_n) signal line to select individual memory devices.

It will be understood that in the example of system 800, the bus between memory controller 820 and memory devices 840 includes a subsidiary command bus CMD 834 and a subsidiary bus to carry the write and read data, DQ 836. In one embodiment, the data bus can include bidirectional lines for read data and for write/command data. In another embodiment, the subsidiary bus DQ 836 can include unidirectional write signal lines for write and data from the host to memory and can include unidirectional lines for read data from the memory to the host. In accordance with the chosen memory technology and system design, other signals 838 may accompany a bus or sub bus, such as strobe lines DQS. Based on design of system 800, or implementation if a design supports multiple implementations, the data bus can have more or less bandwidth per memory device 840. For example, the data bus can support memory devices that have either a x32 interface, a x16 interface, a x8 interface, or other interface. The convention "xW," where W is an integer that refers to an interface size or width of the interface of memory device 840, which represents a number of signal lines to exchange data with memory controller 820. The interface size of the memory devices is a controlling factor on how many memory devices can be used concurrently per channel in system 800 or coupled in parallel to the same signal lines. In one embodiment, high bandwidth memory devices, wide interface devices, or stacked memory configurations, or combinations, can enable wider interfaces, such as a x128 interface, a x256 interface, a x512 interface, a x1024 interface, or other data bus interface width.

In one embodiment, memory devices 840 and memory controller 820 exchange data over the data bus in a burst, or a sequence of consecutive data transfers. The burst corresponds to a number of transfer cycles, which is related to a bus frequency. In one embodiment, the transfer cycle can be a whole clock cycle for transfers occurring on a same clock or strobe signal edge (e.g., on the rising edge). In one embodiment, every clock cycle, referring to a cycle of the system clock, is separated into multiple unit intervals (UIs), where each UI is a transfer cycle. For example, double data rate transfers trigger on both edges of the clock signal (e.g., rising and falling). A burst can last for a configured number of UIs, which can be a configuration stored in a register, or triggered on the fly. For example, a sequence of eight consecutive transfer periods can be considered a burst length 8 (BL8), and each memory device 840 can transfer data on each UI. Thus, a x8 memory device operating on BL8 can transfer 64 bits of data (8 data signal lines times 8 data bits transferred per line over the burst). It will be understood that this simple example is merely an illustration and is not limiting.

Memory devices 840 represent memory resources for system 800. In one embodiment, each memory device 840 is a separate memory die. In one embodiment, each memory device 840 can interface with multiple (e.g., 2) channels per device or die. Each memory device 840 includes I/O interface logic 842, which has a bandwidth determined by the implementation of the device (e.g., x16 or x8 or some other interface bandwidth). I/O interface logic 842 enables the memory devices to interface with memory controller 820. I/O interface logic 842 can include a hardware interface and can be in accordance with I/O 822 of memory controller, but at the memory device end. In one embodiment, multiple memory devices 840 are connected in parallel to the same command and data buses. In another embodiment, multiple memory devices 840 are connected in parallel to the same command bus and are connected to different data buses. For example, system 800 can be configured with multiple memory devices 840 coupled in parallel, with each memory device responding to a command, and accessing memory resources 860 internal to each. For a Write operation, an individual memory device 840 can write a portion of the overall data word, and for a Read operation, an individual memory device 840 can fetch a portion of the overall data word. As non-limiting examples, a specific memory device can provide or receive, respectively, 8 bits of a 128-bit data word for a Read or Write transaction, or 8 bits or 16 bits (depending for a x8 or a x16 device) of a 256-bit data word. The remaining bits of the word will be provided or received by other memory devices in parallel.

In one embodiment, memory devices 840 are disposed directly on a motherboard or host system platform (e.g., a PCB (printed circuit board) on which processor 810 is disposed) of a computing device. In one embodiment, memory devices 840 can be organized into memory modules 870. In one embodiment, memory modules 870 represent dual inline memory modules (DIMMs).

In one embodiment, memory modules 870 represent other organization of multiple memory devices to share at least a portion of access or control circuitry, which can be a separate circuit, a separate device, or a separate board from the host system platform. Memory modules 870 can include multiple memory devices 840, and the memory modules can include support for multiple separate channels to the included memory devices disposed on them. In another embodiment, memory devices 840 may be incorporated into the same package as memory controller 820, such as by techniques such as multi-chip-module (MCM), package-on-package, through-silicon via (TSV), or other techniques or combinations. Similarly, in one embodiment, multiple memory devices 840 may be incorporated into memory modules 870, which themselves may be incorporated into the same package as memory controller 820. It will be appreciated that for these and other embodiments, memory controller 820 may be part of host processor 810.

Memory devices 840 each include memory resources 860. Memory resources 860 represent individual arrays of memory locations or storage locations for data. Typically, memory resources 860 are managed as rows of data, accessed via wordline (rows) and bitline (individual bits within a row) control. Memory resources 860 can be organized as separate channels, ranks, and banks of memory. Channels may refer to independent control paths to storage locations within memory devices 840. A rank refers to memory devices coupled with the same chip select. Ranks may refer to common locations across multiple memory devices (e.g., same row addresses within different devices). Banks may refer to arrays of memory locations within a memory device 840. In one embodiment, banks of memory are divided into sub-banks with at least a portion of shared circuitry (e.g., drivers, signal lines, control logic) for the sub-banks, allowing separate addressing and access. It will be understood that channels, ranks, banks, sub-banks, bank groups, or other organizations of the memory locations, and combinations of the organizations, can overlap in their application to physical resources. For example, the same physical memory locations can be accessed over a specific channel as a specific bank, which can also belong to a rank. Thus, the organization of memory resources will be understood in an inclusive, rather than exclusive, manner.

In one embodiment, memory devices 840 include one or more registers 844. Register 844 represents one or more storage devices or storage locations that provide configuration or settings for the operation of the memory device. In one embodiment, register 844 can provide a storage location for memory device 840 to store data for access by memory controller 820 as part of a control or management operation. In one embodiment, register 844 includes one or more Mode Registers. In one embodiment, register 844 includes one or more multipurpose registers. The configuration of locations within register 844 can configure memory device 840 to operate in different "modes," where command information can trigger different operations within memory device 840 based on the mode. Additionally, or in the alternative, different modes can also trigger different operation from address information or other signal lines depending on the mode. Settings of register 844 can indicate configuration for I/O settings (e.g., timing, termination or ODT (on-die termination), driver configuration, or other I/O settings).

Memory device 840 includes controller 850, which represents control logic within the memory device to control internal operations within the memory device. For example, controller 850 decodes commands sent by memory controller 820 and generates internal operations to execute or satisfy the commands. Controller 850 can be referred to as an internal controller and is separate from memory controller 820 of the host. Controller 850 can determine what mode is selected based on register 844 and configure the internal execution of operations for access to memory resources 860 or other operations based on the selected mode. Controller 850 generates control signals to control the routing of bits within memory device 840 to provide a proper interface for the selected mode and direct a command to the proper memory locations or addresses. Controller 850 includes command logic 852, which can decode command encoding received on command and address signal lines. Thus, command logic 852 can be or include a command decoder. With command logic 852, memory device can identify commands and generate internal operations to execute requested commands.

Referring again to memory controller 820, memory controller 820 includes command (CMD) logic 824, which represents logic or circuitry to generate commands to send to memory devices 840. The generation of the commands can refer to the command prior to scheduling, or the preparation of queued commands ready to be sent. Generally, the signaling in memory subsystems includes address information within or accompanying the command to indicate or select one or more memory locations where the memory devices should execute the command. In response to scheduling of transactions for memory device 840, memory controller 820 can issue commands via I/O 822 to cause memory device 840 to execute the commands. In one embodiment, controller 850 of memory device 840 receives and decodes command and address information received via I/O 842 from memory controller 820. Based on the received command and address information, controller 850 can control the timing of operations of the logic and circuitry within memory device 840 to execute the commands. Controller 850 is responsible for compliance with standards or specifications within memory device 840, such as timing and signaling requirements. Memory controller 820 can implement compliance with standards or specifications by access scheduling and control.

Memory controller 820 includes scheduler 830, which represents logic or circuitry to generate and order transactions to send to memory device 840. From one perspective, the primary function of memory controller 820 could be said to schedule memory access and other transactions to memory device 840. Such scheduling can include generating the transactions themselves to implement the requests for data by processor 810 and to maintain integrity of the data (e.g., such as with commands related to refresh). Transactions can include one or more commands, and result in the transfer of commands or data or both over one or multiple timing cycles such as clock cycles or unit intervals. Transactions can be for access such as read or write or related commands or a combination, and other transactions can include memory management commands for configuration, settings, data integrity, or other commands or a combination.

Memory controller 820 typically includes logic such as scheduler 830 to allow selection and ordering of transactions to improve performance of system 800. Thus, memory controller 820 can select which of the outstanding transactions should be sent to memory device 840 in which order, which is typically achieved with logic much more complex that a simple first-in first-out algorithm. Memory controller 820 manages the transmission of the transactions to memory device 840, and manages the timing associated with the transaction. In one embodiment, transactions have deterministic timing, which can be managed by memory controller 820 and used in determining how to schedule the transactions with scheduler 830.

In one example, the memory device includes circuitry 845 to provide access to read metadata from and write metadata to the on-die ECC bits. For example, the circuitry 845 is to provide the metadata stored in the on-die ECC bits in response to a read request, and write the metadata to the on-die ECC bits in response to a write request. In one example, the register 844 includes one or more registers to enable or disable the I/O capability of the on-die ECC pin of the device.

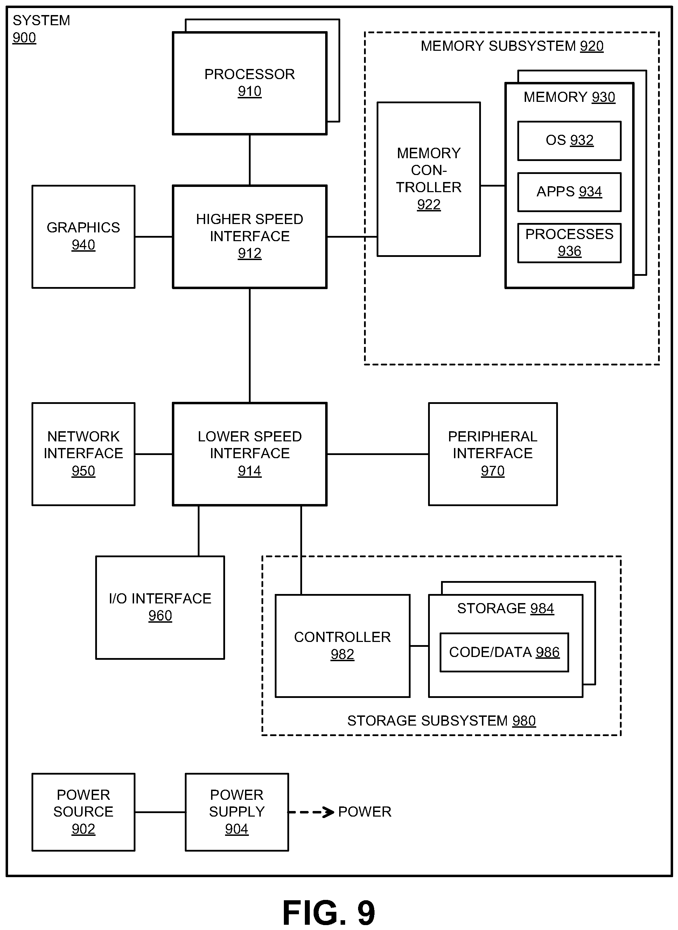

**Figure 9** is a block diagram of an embodiment of a computing system in which techniques for storing and accessing metadata within selective DRAM devices can be implemented. System 900 represents a computing device in accordance with any embodiment described herein, and can be a laptop computer, a desktop computer, a tablet computer, a server, a gaming or entertainment control system, a scanner, copier, printer, routing or switching device, embedded computing device, a smartphone, a wearable device, an internet-of-things device, or other electronic device.

System 900 includes processor 910, which provides processing, operation management, and execution of instructions for system 900. Processor 910 can include any type of microprocessor, central processing unit (CPU), graphics processing unit (GPU), processing core, or other processing hardware to provide processing for system 900, or a combination of processors. Processor 910 controls the overall operation of system 900, and can be or include, one or more programmable general-purpose or special-purpose microprocessors, digital signal processors (DSPs), programmable controllers, application specific integrated circuits (ASICs), programmable logic devices (PLDs), or the like, or a combination of such devices.

In one embodiment, system 900 includes interface 912 coupled to processor 910, which can represent a higher speed interface or a high throughput interface for system components that needs higher bandwidth connections, such as memory subsystem 920 or graphics interface components 940. Interface 912 represents an interface circuit, which can be a standalone component or integrated onto a processor die. Where present, graphics interface 940 interfaces to graphics components for providing a visual display to a user of system 900. In one embodiment, graphics interface 940 can drive a high definition (HD) display that provides an output to a user. High definition can refer to a display having a pixel density of approximately 100 PPI (pixels per inch) or greater and can include formats such as full HD (e.g., 1080p), retina displays, 4K (ultra-high definition or UHD), or others. In one embodiment, the display can include a touchscreen display. In one embodiment, graphics interface 940 generates a display based on data stored in memory 930 or based on operations executed by processor 910 or both. In one embodiment, graphics interface 940 generates a display based on data stored in memory 930 or based on operations executed by processor 910 or both.

Memory subsystem 920 represents the main memory of system 900 and provides storage for code to be executed by processor 910, or data values to be used in executing a routine. Memory subsystem 920 can include one or more memory devices 930 such as read-only memory (ROM), flash memory, one or more varieties of random-access memory (RAM) such as DRAM, or other memory devices, or a combination of such devices. Memory 930 stores and hosts, among other things, operating system (OS) 932 to provide a software platform for execution of instructions in system 900. Additionally, applications 934 can execute on the software platform of OS 932 from memory 930. Applications 934 represent programs that have their own operational logic to perform execution of one or more functions. Processes 936 represent agents or routines that provide auxiliary functions to OS 932 or one or more applications 934 or a combination. OS 932, applications 934, and processes 936 provide software logic to provide functions for system 900. In one embodiment, memory subsystem 920 includes memory controller 922, which is a memory controller to generate and issue commands to memory 930. It will be understood that memory controller 922 could be a physical part of processor 910 or a physical part of interface 912. For example, memory controller 922 can be an integrated memory controller, integrated onto a circuit with processor 910.

While not specifically illustrated, it will be understood that system 900 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or an Institute of Electrical and Electronics Engineers (IEEE) standard 1394 bus.

In one embodiment, system 900 includes interface 914, which can be coupled to interface 912. Interface 914 can be a lower speed interface than interface 912. In one embodiment, interface 914 represents an interface circuit, which can include standalone components and integrated circuitry. In one embodiment, multiple user interface components or peripheral components, or both, couple to interface 914. Network interface 950 provides system 900 the ability to communicate with remote devices (e.g., servers or other computing devices) over one or more networks. Network interface 950 can include an Ethernet adapter, wireless interconnection components, cellular network interconnection components, USB (universal serial bus), or other wired or wireless standards-based or proprietary interfaces. Network interface 950 can exchange data with a remote device, which can include sending data stored in memory or receiving data to be stored in memory.

In one embodiment, system 900 includes one or more input/output (I/O) interface(s) 960. I/O interface 960 can include one or more interface components through which a user interacts with system 900 (e.g., audio, alphanumeric, tactile/touch, or other interfacing). Peripheral interface 970 can include any hardware interface not specifically mentioned above. Peripherals refer generally to devices that connect dependently to system 900. A dependent connection is one where system 900 provides the software platform or hardware platform or both on which operation executes, and with which a user interacts.

In one embodiment, system 900 includes storage subsystem 980 to store data in a nonvolatile manner. In one embodiment, in certain system implementations, at least certain components of storage 980 can overlap with components of memory subsystem 920. Storage subsystem 980 includes storage device(s) 984, which can be or include any conventional medium for storing large amounts of data in a nonvolatile manner, such as one or more magnetic, solid state, or optical based disks, or a combination. Storage 984 holds code or instructions and data 986 in a persistent state (i.e., the value is retained despite interruption of power to system 900). Storage 984 can be generically considered to be a "memory," although memory 930 is typically the executing or operating memory to provide instructions to processor 910. Whereas storage 984 is nonvolatile, memory 930 can include volatile memory (i.e., the value or state of the data is indeterminate if power is interrupted to system 900). In one embodiment, storage subsystem 980 includes controller 982 to interface with storage 984. In one embodiment controller 982 is a physical part of interface 914 or processor 910 or can include circuits or logic in both processor 910 and interface 914.

Power source 902 provides power to the components of system 900. More specifically, power source 902 typically interfaces to one or multiple power supplies 904 in system 900 to provide power to the components of system 900. In one embodiment, power supply 904 includes an AC to DC (alternating current to direct current) adapter to plug into a wall outlet. Such AC power can be renewable energy (e.g., solar power) power source 902. In one embodiment, power source 902 includes a DC power source, such as an external AC to DC converter. In one embodiment, power source 902 or power supply 904 includes wireless charging hardware to charge via proximity to a charging field. In one embodiment, power source 902 can include an internal battery or fuel cell source.

Thus, techniques for storing and accessing metadata as described herein can enable metadata storage without compromising the RAS/ECC coverage of the data and without additional capacity reduction for metadata storage. Additionally, the techniques described herein enable accessing the metadata in parallel with the data bits and transmitting them on one or more separate channels such that no extended burst is needed, nor additional time added to core timing parameters.

Examples of techniques for storing and accessing metadata within selective DRAM devices follow.

Example 1: A dual in-line memory module (DIMM) including a plurality of dynamic random access memory (DRAM) devices, wherein each of plurality of DRAM devices includes on-die ECC bits, and wherein at least one of the plurality of DRAM devices includes circuitry to provide access to read from and write to the on-die ECC bits of the DRAM device, and a pin to transmit metadata to and from the on-die ECC bits of the DRAM device.

Example 2: The DIMM of example 1, wherein: the DRAM device includes an on-die ECC pin coupled with the pin of the DIMM to transmit metadata to and from the on-die ECC bits of the DRAM device.

Example 3: The DIMM of example 1 or 2, wherein: the circuitry of the DRAM device is to provide the metadata stored in the on-die ECC bits in response to a read request.

Example 4: The DIMM of any of examples 1-3, wherein: the DRAM device includes circuitry to write the metadata to the on-die ECC bits in response to a write request.

Example 5: The DIMM of any of examples 1-4, wherein: the DRAM device includes one or more registers to store a value to enable reading metadata from and writing metadata to the on-die ECC bits.

Example 6: The DIMM of any of examples 1-5, wherein: the DRAM device to provide access to read from and write to the on-die ECC bits is an ECC device of the DIMM.

Example 7: The DIMM of any of examples 1-6, wherein: the on-die ECC pin of only one of the plurality of DRAM devices per channel is coupled with the pin of the DIMM.

Example 8: The DIMM of any of examples 1-7, wherein: the on-die ECC pin of multiple DRAM devices of the plurality of DRAM devices are coupled with the pin of the DIMM.

Example 9: The DIMM of example 8, further including: a data buffer to collate the metadata to and from the on-die ECC bits of the multiple DRAM devices.

Example 10: The DIMM of any of examples 1-9, wherein: the on-die ECC pin of selected DRAM devices of the plurality of DRAM devices is coupled with the pin of the DIMM, and the on-die ECC pin of unselected DRAM devices of the plurality of DRAM devices is open, or tied to VDD or VSS.

Example 11: A memory device including: on-die error correction code (ECC) bits, circuitry to provide access to read from and write to the on-die ECC bits, and one or more input/output (I/O) pins to transmit metadata to and from the on-die ECC bits.

Example 12: The memory device of example 11, wherein: the circuitry is to provide the metadata stored in the on-die ECC bits in response to a read request.

Example 13: The memory device of example 11 or 12, wherein: the circuitry is to write the metadata to the on-die ECC bits in response to a write request.

Example 14: The memory device of any of examples 11-13, further including: one or more registers to store a value to enable reading metadata from and writing metadata to the on-die ECC bits of the memory device.

Example 15: A system including: a motherboard including a dual in-line memory module (DIMM) connector, and a DIMM including a plurality of dynamic random access memory (DRAM) devices, wherein at least one of DRAM devices includes on-die ECC bits, and wherein at least one of the plurality of DRAM devices includes circuitry to provide access to read from and write to the on-die ECC bits of the DRAM device, and a plurality of conductive contacts proximate to an edge of the DIMM to be received by the DIMM connector, wherein one or more of conductive contacts is to transmit metadata to and from the on-die ECC bits of at least one of the DRAM devices.

Example 16. The system of example 15, wherein: the DRAM device to provide access to read from and write to the on-die ECC bits is an ECC device of the DIMM.

Example 17: The system of example 15 or 16, wherein: the on-die ECC pin of only one of the plurality of DRAM devices is coupled with the one or more conductive contacts of the DIMM.

Example 18: The system of any of examples 15-17, wherein: the on-die ECC pin of multiple DRAM devices of the plurality of DRAM devices are coupled with the one or more conductive contacts of the DIMM.

Example 19: The system of example 18, further including: a data buffer to collate the metadata to and from the on-die ECC bits of the multiple DRAM devices.

Example 20: The system of any of examples 15-19, further including one or more of: a memory controller, a processor, and a display.

Flow diagrams as illustrated herein provide examples of sequences of various process actions. The flow diagrams can indicate operations to be executed by a software or firmware routine, as well as physical operations. In one embodiment, a flow diagram can illustrate the state of a finite state machine (FSM), which can be implemented in hardware and/or software. Although shown in a particular sequence or order, unless otherwise specified, the order of the actions can be modified. Thus, the illustrated embodiments should be understood only as an example, and the process can be performed in a different order, and some actions can be performed in parallel. Additionally, one or more actions can be omitted in various embodiments; thus, not all actions are required in every embodiment. Other process flows are possible.

To the extent various operations or functions are described herein, they can be described or defined as software code, instructions, configuration, and/or data. The content can be directly executable ("object" or "executable" form), source code, or difference code ("delta" or "patch" code). The software content of the embodiments described herein can be provided via an article of manufacture with the content stored thereon, or via a method of operating a communication interface to send data via the communication interface. A machine readable storage medium can cause a machine to perform the functions or operations described and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

The hardware design embodiments discussed above may be embodied within a semiconductor chip and/or as a description of a circuit design for eventual targeting toward a semiconductor manufacturing process. In the case of the later, such circuit descriptions may take of the form of a (e.g., VHDL or Verilog) register transfer level (RTL) circuit description, a gate level circuit description, a transistor level circuit description or mask description or various combinations thereof. Circuit descriptions are typically embodied on a computer readable storage medium (such as a CD-ROM or other type of storage technology).

Besides what is described herein, various modifications can be made to the disclosed embodiments and implementations of the invention without departing from their scope. Therefore, the illustrations and examples herein should be construed in an illustrative, and not a restrictive sense. The scope of the invention should be measured solely by reference to the claims that follow.

## Claims

1. An apparatus comprising:
a dual in-line memory module (DIMM) (100) including:
a plurality of dynamic random access memory (DRAM) devices (102-1 - 102-N), wherein each of plurality of DRAM devices includes on-die ECC bits (106), and wherein at least one of the plurality of DRAM devices includes circuitry (845) to provide access to read from and write to the on-die ECC bits of the DRAM device; and
a pin (114) to transmit metadata to and from the on-die ECC bits of the DRAM device.

2. The apparatus of claim 1, wherein:
the DRAM device includes an on-die ECC pin coupled with the pin of the DIMM to transmit metadata to and from the on-die ECC bits of the DRAM device.

3. The apparatus of claims 1 or 2, wherein:
the circuitry of the DRAM device is to provide the metadata stored in the on-die ECC bits in response to a read request.

4. The apparatus of any one of claims 1-3, wherein:
the DRAM device includes circuitry to write the metadata to the on-die ECC bits in response to a write request.

5. The apparatus of any one of claims 1-4, wherein:
the circuitry is to read or write the metadata stored in the on-die ECC bits in parallel with reading or writing data bits.

6. The apparatus of any one of claims 1-5, wherein:
the circuitry is to provide access to the on-die ECC bits for every read and write for all addresses.

7. The apparatus of any one of claims 1-6, wherein:
the DRAM device includes one or more registers to store a value to enable reading metadata from and writing metadata to the on-die ECC bits.

8. The apparatus of any one of claims 1-7, wherein:
the DRAM device to provide access to read from and write to the on-die ECC bits is an ECC device of the DIMM.

9. The apparatus of any one of claims 1-7, wherein:
the DRAM device to provide access to read from and write to the on-die ECC bits is a data DRAM device of the DIMM.

10. The apparatus of any one of claims 1-9, wherein:
each of the plurality of DRAM devices includes an on-die ECC pin; and
the on-die ECC pin of only one of the plurality of DRAM devices per channel is coupled with the pin of the DIMM.

11. The apparatus of any one of claims 1-9, wherein:
each of the plurality of DRAM devices includes an on-die ECC pin; and
the on-die ECC pin of multiple DRAM devices of the plurality of DRAM devices are coupled with the pin of the DIMM.

12. The apparatus of claim 11, further comprising:
a data buffer to collate the metadata to and from the on-die ECC bits of the multiple DRAM devices.

13. The apparatus of any one of claims 1-12, wherein:
each of the plurality of DRAM devices includes an on-die ECC pin;
one or a subset of the plurality of DRAM devices are selected DRAM devices for storing metadata in respective on-die ECC bits and remaining DRAM devices of the plurality of DRAM devices are unselected DRAM devices;
the on-die ECC pin of the selected DRAM devices of the plurality of DRAM devices is coupled with the pin of the DIMM; and
the on-die ECC pin of the unselected DRAM devices of the plurality of DRAM devices is open, or tied to VDD or VSS.

14. The apparatus of any of claims 1-13, further including:
a motherboard including a DIMM connector to receive the DIMM.

15. The apparatus of any of claims 1-14, further comprising:
a memory controller to access the metadata stored in the on-die ECC bits of the DRAM device.
